# EUROPÄISCHE PATENTSCHRIFT

(11) **EP 0 281 808 B1**
(45) Veröffentlichungstag und Bekanntmachung des Hinweises auf die Patenterteilung: **20.07.1994**
(21) Anmeldenummer: 88102309.7
(22) Anmeldetag: 17.02.1988
(51) Int. Cl.: G03F 7/038

(54) **Strahlungsvernetzbares Polymersystem zur Anwendung als Photoresist und Dielektrikum für Mikroverdrahtungen**
Radiation cross-linkable polymer system for application as photoresist and dielectric for micro wiring
Système de polymères réticulables par radiation pour application comme photorésist et diélectrique pour microcomposant

(30) Priorität: 12.03.1987 DE 3708057
(43) Veröffentlichungstag der Anmeldung: 14.09.1988
(73) Patentinhaber: SIEMENS AKTIENGESELLSCHAFT, 80333 München (DE)
(72) Erfinder: Budde, Klaus, Dr. Dipl.-Chem., D-8025 Unterhaching (DE)

(56) Entgegenhaltungen:
- EP-A- 0 167 051
- EP-A- 0 174 494
- EP-A- 0 204 292
- FR-A- 2 259 863
- FR-A- 2 440 978
- US-A- 3 738 973

## Beschreibung

Die Erfindung betrifft ein thermostabiles, strahlungsvernetzbares, ohne zusätzliche Temperung härtendes Polymersystem mit substituierten Acrylesterendgruppen als vernetzendem Strukturelement, wie es insbesondere als Dielektrikum und Negativphotoresist für Mikroverdrahtungen verwendet wird.

Die Ausbildung von Strukturen, insbesondere Leiterbahnen von Mikroverdrahtungen in der Mikroelektronik geschieht fast ausschließlich mit Hilfe von Photoresists. Auf aus Photoresistmaterial bestehenden Lackschichten lassen sich mittels optischer Verfahren latente Bilder erzeugen. Nach einem Entwicklungsprozeß verbleibt eine Lackstruktur, die dem Bild der Vorlage entspricht und als Maske für weitere Schritte, zum Beispiel Ätzprozesse dienen kann. Bei einem Negativphotolack wird eine Polymervorstufe eines geeigneten Kunststoffes zum Beispiel durch UV-Bestrahlung durch eine Maske in den belichteten Teilen vernetzt und dadurch an diesen Stellen in seiner Löslichkeit herabgesetzt. Nicht belichtete Teile können in einem geeigneten Lösungsmittel herausgelöst werden. Die stehengebliebene Struktur entspricht dem negativen Bild der Maske.

Üblich sind zum Beispiel Photolacke auf der Basis von olefinische Gruppen tragenden Oligomeren bzw. Polymeren wie zum Beispiel aus der DE-OS 29 44 097 bekannt ist. Doch sind die bekannten Photoresists meist nicht oder schlecht zum Verbleib auf dem fertigen elektrischen bzw. elektronischen Bauteil geeignet, weil sie den elektrischen oder mechanischen Belastungen, die beim Betrieb des Bauteils auftreten können, nicht standhalten können und zu fehlerhaftem Betrieb bzw. Zerstörung des Bauteils führen.

Aus der EP-A 0 204 292 ist ein Photopolymersystem mit niedriger Dielektrizitätskonstante bekannt. Es basiert auf einem Polyglycidylether, der mit Furanacrylsäure verestert ist und Phenoxy- oder Epoxyendgruppen aufweist.

Aus der FR-A 2 259 863 ist ein Photopolymersystem auf der Basis von mit Furanacrylsäure verestertem Phenoxyharz bekannt.

Aus der US-3 738 973 sind lichtempfindliche Polymere auf der Basis von Polyester und Glycidylester bekannt, die zumindest teilweise mit Furanacrylsäure verestert sind.

Aufgabe der Erfindung ist es daher, ein Polymersystem insbesondere für Mikroverdrahtungen anzugeben, das eine hohe UV-Empfindlichkeit zeigt, im gehärteten Zustand eine Glasübergangstemperatur von größer/gleich 120°C, thermische Dauerbeständigkeit bei Temperaturen größer 100°C zeigt und außerdem eine Dielektrizitätskonstante kleiner 3,5 sowie Lötbadbeständigkeit aufweist.

Diese Aufgabe wird erfindungsgemäß durch ein Polymersystem mit den Merkmalen von Anspruch 1 gelöst.

Weiterhin liegt es im Rahmen der Erfindung, daß der Anteil der Komponente B im gesamten Polymersystem zwischen 1 und 5 Gewichtsprozent beträgt.

Weitere Ausgestaltungen der Erfindung sind den Unteransprüchen zu entnehmen.

Die vorzugsweise verwendeten oligo- bzw. polymeren Acrylate von Zimtsäure und Furanacrylsäure lassen sich durch Umsetzung der entsprechenden Säurechloride mit niedermolekularen polyfunktionellen Glycidylethern erhalten. Aus diesen Polymeren lassen sich klare lichtempfindliche Filme von hoher thermischer Beständigkeit herstellen. Durch Zusatz von sogenannten Vernetzungsverstärkern, auch Modifier genannt, lassen sich thermische und mechanische Eigenschaften gezielt einstellen und verbessern. Diese Vernetzungsverstärker sind überwiegend polyfunktionelle niedermolekulare Verbindungen. Tragen diese die gleichen funktionellen Gruppen wie das Polyacrylat und sind diesem somit chemisch verwandt, spricht man auch von reaktivem Verdünner.

Geeignete Vernetzungsverstärker für die erfindungsgemäßen Polyetheracrylate sind daher die Acrylate von Mehrfachalkoholen wie zum Beispiel Pentaerythritoltri- bzw. tetraacrylat, Dipentaerythritolpentaacrylat oder Trimethylolpropantriacrylat.

Entsprechend können für Polyetherpolymethacrylate die entsprechenden Methacrylate der oben erwähnten Mehrfachalkohole eingesetzt werden. Gleiches gilt für die erfindungsgemäßen Polyacrylate mit Cinnamat-Endgruppen. Vernetzungsverstärker können hier die entsprechenden Cinnamate der Mehrfachalkohole sein, aber auch aus Polyvinylalkohol und Zimtsäurechlorid erhältliches Polyvinylcinnamat ist geeignet.

In einer weiteren vorteilhaften Ausgestaltung der Erfindung wird als Hauptkomponente A ein aus Bisphenol A und Epichlorhydrin aufgebauter Polyglycidylether eingesetzt, dessen freie OH-Gruppen mit entsprechenden Acrylsäuren, vorzugsweise Zimtsäure oder Furanacrylsäure verestert sind. Solche Polymere sind beispielsweise aus der europäischen Patentanmeldung 0 167 051 zu entnehmen und lassen sich durch folgende allgemeine Struktur (4) beschreiben: 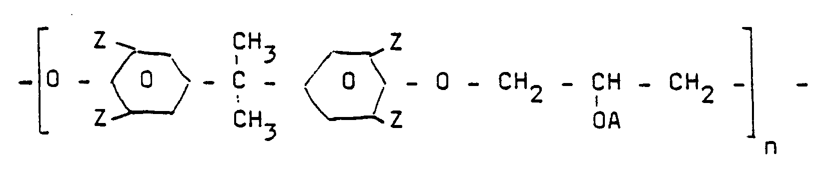
wobei Z = H oder -CH₂OA,
A der Acylrest einer Acrylsäure, vorzugsweise Zimtsäure oder Furanacrylsäure und n eine ganze Zahl bedeutet. Dabei ist n so gewählt, daß die mittlere Molmasse des Polymeren ca. 10.000 Gramm/mol beträgt. Als Nebenkomponente B werden Polyetherpolyacrylate der allgemeinen Strukturen (1), (2) und (3) zugesetzt.

Die aus diesem Polymersystem durch UV-Härtung erhaltenen Harze zeigen ausreichend hohe Glasübergangstemperaturen und niedrige Dielektrizitätskonstanten (kleiner gleich 3,1). Auch gegenüber thermischer Dauerbelastung bei Temperaturen von über 100°C zeigen diese Harze eine hervorragende Beständigkeit und sind daher bestens zur Herstellung von Mikroverdrahtungen geeignet.

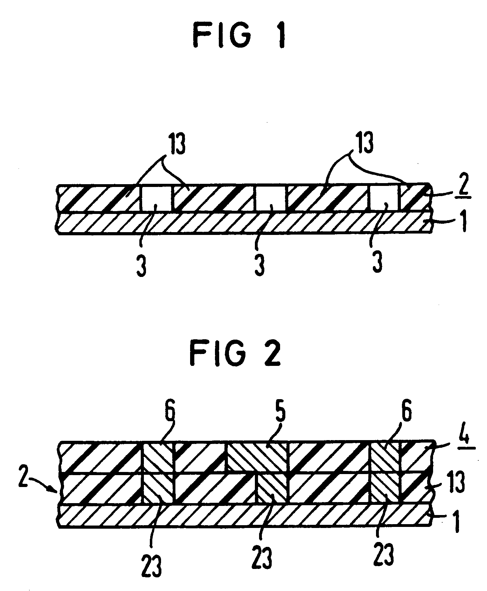

In einem Ausführungsbeispiel wird im folgenden die Darstellung eines erfindungsgemäßen Polymersystems beschrieben und anhand der Figuren 1 und 2 die Anwendung des Polymersystems bei der Herstellung einer Mehrlagenverdrahtung beschrieben. Dabei zeigen
- die Figuren 1 und 2: im Schnittbild die wesentlichsten Verfahrensschritte.

Zur Darstellung eines der allgemeinen Struktur (1) entsprechenden Acrylats wird vom entsprechenden Trisepoxid (5) ausgegangen. 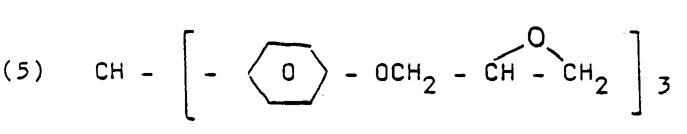
Das bei Raumtemperatur feste Trisepoxid (5) wird in der vierfachen Menge Toluol p.a. gelöst. Dazu gibt man über Nacht bei 50°C über einem Trockenmittel vorgetrocknetes Zimtsäurechlorid in etwa 15 % Überschuß zur Stöchiometrie (entspricht 0,46 Massenteile bezogen auf Epoxid). Darauf wird die Mischung ca. 20 Stunden unter Rückfluß gekocht, wobei sich die Komponenten miteinander umsetzen. Das Rohprodukt wird durch Eingießen in die fünffache Menge Methanol p.a. ausgefällt und nach Abtrennen vom Lösungsmittel bei 50°C im Vakuum getrocknet. Gegebenenfalls wird das Ausfällen zum Erzielen eines höheren Reinheitsgrades wiederholt.

Das trockene Produkt wird dann zusammen mit 5 Gewichtsprozent Pentaerythritoltetraacrylat in einer der Weiterverarbeitung entsprechenden Menge Toluol gelöst. Man erhält das erfindungsgemäße Polymersystem.

Figur 1: Als Träger der zukünftigen Mikroverdrahtung wird eine Kupferfolie 1 verwendet, auf die eine Schicht 2 des strahlungsvernetzbaren Polymersystems (nach Zusatz von zum Beispiel Michlers Keton als Sensibilisator) durch Tauchen oder Sprühbelacken, beispielsweise in einer Schichtdicke von 5 bis 20 »m aufgebracht wird. Die Schicht 2 wird in der Weise belichtet und entwickelt, daß die in ihr einzufügenden Durchkontaktierungen, das heißt die Anschlußpunkte der Chips als Durchbrechungen 3 in der Isolierstoffschicht 2 entstehen. Die Bestrahlung der Schicht erfolgt dabei unter Verwendung einer Maske (nicht abgebildet), die den Bereich der Durchbrechungen 3 der Schicht 2 abdeckt (Negativlack). Die abgedeckten Teile 3 werden anschließend mit einem entsprechenden Lösungsmittel herausgelöst, während bei den belichteten Teilen 13 der Schicht 2 eine chemische Vernetzung eingetreten ist, die eine Lösung verhindert, so daß diese Teile 13 als Isolierstoffschicht verbleiben. Nach der Herstellung der Durchbrechungen 3 für die dieser ersten Isolierstoffschicht 2 (13) zugeordneten Durchkontaktierungen werden die Durchbrechungen 3 im Zusammenhang mit der als Träger dienenden Kupferfolie 1 mittels galvanischer Metallisierung mit einem elektrisch gut leitenden Material, beispielsweise Kupfer, ausgefüllt (23 in Figur 2).

Figur 2: Anschließend wird auf die die Durchkontaktierungen 23 enthaltende Isolierstoffschicht 13 eine weitere Schicht 4 des photovernetzbaren Isolierstoffes nach der Lehre der Erfindung in der gleichen Weise wie bei Figur 1 beschrieben, aufgebracht, in welche Leitungsbahnen 5 und weitere Durchkontaktierungen 6 eingefügt werden. Die Belichtung und Entwicklung der Schicht 4 erfolgt ebenfalls wie bei Figur 1 beschrieben. Außer den Durchbrechungen 6 für die Durchkontaktierung, die mit den Durchkontaktierungen 3 der ersten Isolierstoffschicht 2 (13) zur Auflage kommen, werden in der zweiten Isolierstoffschicht 4 grabenförmige Aussparungen 5 für die gewünschten Leitungsbahnen erzeugt, wobei diese Aussparungen 5 so angeordnet sind, daß mindestens eine Durchkontaktierung 23 der ersten Isolierstoffschicht (2, 13) in eine Aussparung 5 hineinragt. Zum Aufbau der Leitungsbahnen werden die Aussparungen 5 durch Galvanisieren mit einer Metallisierung versehen. Weitere Durchkontaktierungen und Leiterbahnen können dann durch entsprechende Wiederholung der vorstehend beschriebenen Herstellungsstufen aufgebracht werden.

Der neuartige Verdrahtungsaufbau hat gegenüber bekannten Systemen nicht nur den Vorteil einer wesentlich kürzeren Belichtungszeit, sondern erfordert auch keine Zwischen- oder Endtemperungen, durch welche Zersetzungsprodukte entstehen können, die die Struktur verändern. Ebenso erübrigt sich die Verwendung von weiteren Passivierungsschichten. Dadurch vereinfacht sich nicht nur das Verfahren zur Herstellung eines solchen Aufbaus, sondern auch die Zuverlässigkeit in bezug auf die elektrischen Daten.

## Patentansprüche

1. Thermostabiles, strahlungsvernetzbares, ohne zusätzliche Temperung härtendes Polymersystem, bestehend aus einer Hauptkomponente A, die ein Polyetheracrylat oder eine Verbindung gemäß einer der Strukturformeln (1),(2) oder (3) ist, und 1 bis 10 Gewichtsprozent einer davon unterschiedlichen Komponente B als Vernetzungsverstärker, welche ausgewählt ist aus Pentaerythritoltri- bzw. tetraacrylat, Dipentaerythritolpentaacrylat oder Trimethylolpropantriacrylat ist (für Haupt komponente A = (1), (2) oder (3)) oder einer der allgemeinen Strukturen (1), (2) oder (3) gehorcht (für Haupt komponente A = Polyetheracrylat),
(1) CHY₃
(2) CHY₂ - CHY₂
(3) 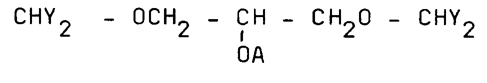
wobei Y für einen Rest der Struktur 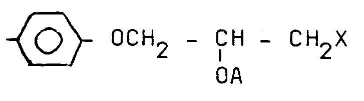 steht mit X = H, Cl oder OH und wobei A den Acylrest einer substituierten Acrylsäure darstellt.

2. Polymersystem nach Anspruch 1,
bei dem der Anteil der Komponente B im gesamten Polymersystem zwischen 1 und 5 Gewichtsprozent beträgt.

3. Polymersystem nach Anspruch 1 oder 2,
bei dem das Polyetheracrylat die allgemeine Struktur 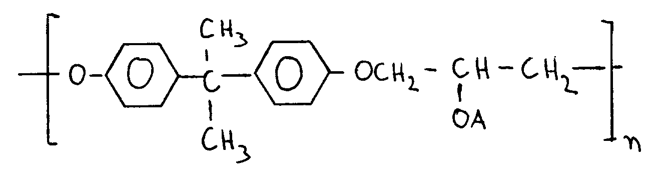 besitzt, wobei n so gewählt ist, daß die mittlere Molmasse ca. 10.000 gr/mol beträgt.

4. Polymersystem nach einem der Ansprüche 1 bis 3,
bei dem die substituierte Acrylsäure Zimtsäure ist.

5. Polymersystem nach einem der Ansprüche 1 bis 3,
bei dem die substituierte Acrylsäure Furanacrylsäure ist.

6. Polymersystem nach Anspruch 3,
bei dem der Bisphenol A-Baustein des Polyetheracrylats noch 1 bis 2 mit einer Acrylsäure veresterte Methylolgruppen an jedem aromatischen Ring trägt.

7. Polymersystem nach Anspruch 1,
bei dem die Komponente A ein mit Zimtsäure verestertes Polyetherpolyacrylat ist und die Komponente B abweichend von Anspruch 1 aus Polyvinylalkohol und Zimtsäurechlorid erhältliches Polyvinylcinnamat ist.

8. Verwendung des Polymersystems nach einem der Ansprüche 1 bis 7, als Dielektrikum und Negativphotoresist für Mikroverdrahtungen.

## Claims

1. Thermally stable, radiation-crosslinkable polymer system which cures without additional heat treatment, comprising a main component A which is a polyether acrylate or a compound in accordance with one of the structural formulae (1), (2), or (3), and 1 to 10 % by weight of a component B, different therefrom, as cross-linking intensifier, which component B is selected from pentaerythritol triacrylate or tetraacrylate, dipentaerythritol pentaacrylate or trimethylolpropane triacrylate is [sic] (for main component A = (1), (2), or (3)) or which conforms to one of the general structures (1), (2), or (3) (for main component A = polyether acrylate),
(1) CHY₃
(2) CHY₂ - CHY₂
(3) 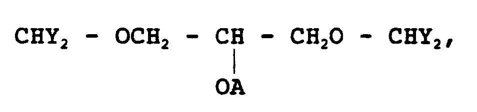
where Y denotes a radical of the structure 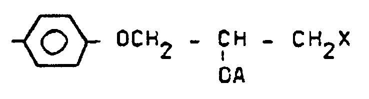 in which X = H, Cl, or OH and where A denotes the acyl radical of a substituted acrylic acid.

2. Polymer system according to Claim 1, in which the proportion of the component B in the entire polymer system is between 1 and 5 % by weight.

3. Polymer system according to Claim 1 or 2, in which the polyether acrylate has the general structure 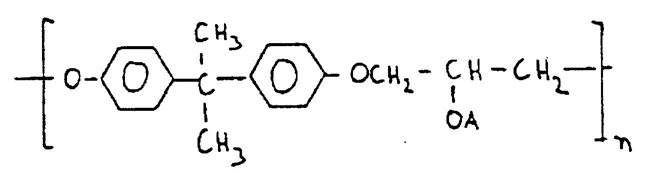 where n is chosen so that the mean molar mass is approximately 10,000 g/mol.

4. Polymer system according to one of Claims 1 to 3, in which the substituted acrylic acid is cinnamic acid.

5. Polymer system according to one of Claims 1 to 3, in which the substituted acrylic acid is furylacrylic acid.

6. Polymer system according to Claim 3, in which the bisphenol A structural element of the polyether acrylate still carries 1 to 2 methylol groups esterified with an acrylic acid on every aromatic ring.

7. Polymer system according to Claim 1, in which the component A is a polyether polyacrylate esterified with cinnamic acid and, as a departure from Claim 1, the component B is polyvinyl cinnamate obtainable from polyvinyl alcohol and cinnamyl chloride.

8. Use of the polymer system according to one of Claims 1 to 7 as a dielectric and as a negative-working photoresist for microinterconnections.

## Revendications

1. Système de polymères thermostable, réticulable par rayonnement, durcissant sans mise en température supplémentaire et constitué d'un constituant A principal, qui est un polyétheracrylate ou un composé suivant l'une des formules (1), (2) ou (3) et de 1 à 10 pour cent en poids d'un constituant B différent servant d'intensificateur de réticulation et choisi parmi le triacrylate de pentaérythrite, le tétraacrylate de pentaérythrite. le pentaacrylate de dipentaérythrite ou l'acrylate de triméthylolpropane (pour le constituant A = (1), (2) ou (3)) ou répond à l'une des structures générales (1), (2) ou (3) (pour le constituant A = polyétheracrylate),
(1) CHY₃,
(2) CHY₂ - CHY₂,
(3) 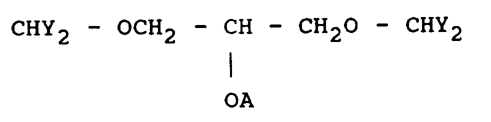
dans lesquelles Y est un radical de structure 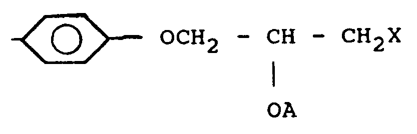 avec X = H, Cl ou OH et A représente le radical alcyle d'un acide acrylique substitué.

2. Système de polymères suivant la revendication 1, dans lequel la proportion du constituant B dans tout le système de polymères est comprise entre 1 et 5 % en poids.

3. Système de polymères suivant la revendication 1 ou 2,
dans lequel le polyétheracrylate a la structure générale 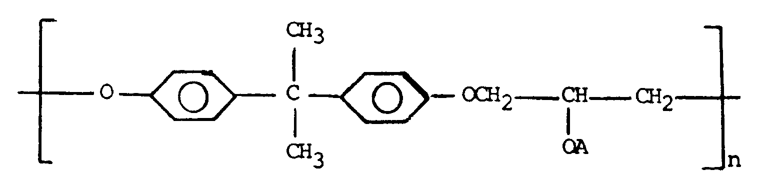 n étant tel que la masse moléculaire moyenne est d'environ 10 g/mole.

4. Système de polymères suivant l'une des revendications 1 à 3, dans lequel l'acide acrylique substitué est l'acide cinnamique.

5. Système de polymères suivant l'une des revendications 1 à 3, dans lequel l'acide acrylique substitué est l'acide furanacrylique.

6. Système de polymères suivant la revendication 3, dans lequel le motif bisphénol-A du polyétheracrylate porte en outre 1 à 2 groupes méthylol estérifiés par un acide acrylique sur chaque cycle aromatique.

7. Système de polymères suivant la revendication 1, dans lequel le constituant A est un polyétherpolyacrylate estérifié par de l'acide cinnamique et le constituant B à la différence de ce qui est indiqué à la revendication 1 est un poly(cinnamate de vinyle) que l'on peut obtenir à partir de l'alcool polyvinylique et du chlorure d'acide cinnamique.

8. Utilisation du système de polymères suivant l'une des revendications 1 à 7 comme diélectrique et comme photorésist négatif pour des microcâblages.
